# EUROPÄISCHE PATENTSCHRIFT

(11) **EP 3 798 039 B1**
(45) Veröffentlichungstag und Bekanntmachung des Hinweises auf die Patenterteilung: **27.12.2023**
(21) Anmeldenummer: 20189624.8
(22) Anmeldetag: 05.08.2020
(51) Int. Cl.: B60L 3/00, B60L 3/04, B60L 58/20, H02J 9/00, H02J 1/08, H02J 1/10, H02J 7/00

(54) **ELEKTRISCHE SCHALTUNGSANORDNUNG FÜR EIN ENERGIESPEICHERSYSTEM UND VERFAHREN ZUM BETREIBEN DER ELEKTRISCHEN SCHALTUNGSANORDNUNG**
ELECTRICAL CIRCUIT ASSEMBLY FOR AN ENERGY STORAGE SYSTEM AND METHOD FOR OPERATING THE ELECTRICAL CIRCUIT ASSEMBLY
ENSEMBLE DE CIRCUITS ÉLECTRIQUES POUR UN SYSTÈME D'ACCUMULATION D'ÉNERGIE ET PROCÉDÉ DE FONCTIONNEMENT DE L'ENSEMBLE DE CIRCUITS ÉLECTRIQUES

(30) Priorität: 27.09.2019 DE 102019214824
(43) Veröffentlichungstag der Anmeldung: 31.03.2021
(73) Patentinhaber: Robert Bosch GmbH, 70442 Stuttgart (DE)
(72) Erfinder: Weber, Jochen, 71679 Asperg (DE); Schneider, Joerg, 71640 Ludwigsburg (DE); Kohn, Peter, 70469 Stuttgart (DE); Kaiser, Thomas, 70569 Stuttgart (DE); Arnold, Sabine, 78337 Oehningen/Wangen (DE)

(56) Entgegenhaltungen:
- EP-A1- 3 354 520
- EP-A1- 3 360 719
- WO-A1-2015/052137
- US-A1- 2018 162 300
- US-A1- 2018 334 118

## Beschreibung

Die Erfindung geht aus von einer elektrischen Schaltungsanordnung für ein Energiespeichersystem mit einem ersten elektrochemischen Energiespeicher und einem zweiten elektrochemischen Energiespeicher, einem Verfahren zum Betreiben der elektrischen Schaltungsanordnung sowie einer Verwendung der elektrischen Schaltungsanordnung gemäß dem Oberbegriff der unabhängigen Ansprüche.

### Stand der Technik

Bei aktuellen Sicherheitskonzepten für Batterien, beispielsweise Lithium-Ionen-Batterien, ist im Fehlerfall, beispielsweise wenn ein Fehler in der Spannungserfassung vorliegt, kein weiterer Betrieb der Batterie möglich. Zur Erfüllung der Sicherheitsmaßnahmen wird die Batterie in einen sicheren Zustand überführt, wodurch die Batterie von einem Energiebordnetz des Fahrzeugs getrennt wird.

Aufgrund zunehmender sicherheitsrelevanter Komponenten auf einem Bordnetz eines Fahrzeugs mit 12V Batterie muss eine Verfügbarkeit eines Energiebordnetzes des Fahrzeugs gewährleistet sein. Dies bedeutet, dass als Sicherheitsziel die gleiche Verfügbarkeit für die 48V Batterie gelten soll. Da dieses Sicherheitsziel auf die 12V Batterie und die 48V Batterie dekomponiert wird, muss ein Auftreten von gleichen Fehlerarten ausgeschlossen werden, so dass bei einem Fehler der 12V Batterie die 48V Batterie nicht ausfallen darf.

Das Dokument KR20190016401 offenbart eine Leistungsumwandlungsvorrichtung für ein Fahrzeug mit einer 48V-Batterie; einen 48V-Ausgangsanschluss, der an eine 48V-Last angeschlossen ist; einen 12V-Ausgangsanschluss, der an eine 12V-Last angeschlossen ist; eine Leistungsrelaisanordnung, die zwischen der 48V-Batterie und dem 48V-Ausgangsanschluss angeordnet ist, um vorgeladen und geschaltet zu werden; einen bidirektionalen Gleichspannungswandler, der zwischen dem 48V-Ausgangsanschluss und dem 12V-Ausgangsanschluss angeordnet ist, um 48V-Leistung und 12V-Leistung zu empfangen, die entsprechend einem Betriebsmodus in 12V- und 48V-Leistung umgewandelt werden sollen; einen Batteriesteuerungsanschluss zum Verbinden der Leistungsrelaisanordnung und einer Batteriesteuereinheit; und einen Wandlersteuerungsanschluss zum Verbinden des bidirektionalen DC-DC-Wandlers und einer Wandlersteuereinheit.

Das Dokument EP1333565 offenbart ein Verfahren und eine Vorrichtung mit faktorisierter Leistungsarchitektur.

Weitere elektrische Schaltungsanordnungen, welche mit zwei Energiespeichern verbunden werden können, sind in den Dokumenten WO 2015/052137 A1, US 2018/334118 A1, EP 3 354 520 A1, US 2018/162300 A1 und EP 3 360 719 A1 gezeigt.

Es ist Aufgabe der vorliegenden Erfindung, den Stand der Technik weiter zu verbessern. Diese Aufgabe wird gelöst durch die Merkmale der unabhängigen Ansprüche.

### Offenbarung der Erfindung

### Vorteile der Erfindung

Die erfindungsgemäße Vorgehensweise mit den kennzeichnenden Merkmalen der unabhängigen Ansprüche weist demgegenüber den Vorteil auf, dass die elektrische Schaltungsanordnung umfasst:
- eine Leiterplatte mit mindestens einer Steuereinheit, die einen ersten Bereich mit elektrischen und/oder elektronischen Komponenten sowie einen zweiten Bereich mit elektrischen und/oder elektronischen Komponenten umfasst, wobei der erste Bereich und der zweite Bereich der Leiterplatte durch einen dritten Bereich voneinander hochohmig getrennt sind;
- einen ersten Anschluss für die elektrische Spannungsversorgung der Komponenten des ersten Bereiches der Leiterplatte mittels dem ersten Energiespeicher;
- einen zweiten Anschluss für die elektrische Spannungsversorgung der Komponenten, die mindestens eine Steuereinheit umfassen, des zweiten Bereiches der Leiterplatte mittels dem zweiten Energiespeicher, wobei eine elektrische Verbindung zwischen dem zweiten Anschluss und der Steuereinheit eine Filterschaltung, einen Gleichspannungswandler sowie ein Schaltelement umfasst, wobei mittels dem Schaltelement die Filterschaltung mit dem Gleichspannungswandler elektrisch verbindbar ist, wodurch die Spannungsversorgung der Steuereinheit unabhängig von dem ersten Energiespeicher durch den zweiten elektrischen Energiespeicher erfolgt.

Dadurch kann die mindestens eine Steuereinheit auch bei einem Ausfall des ersten Energiespeichers weiterbetrieben werden.

Weitere vorteilhafte Ausführungsformen sind Gegenstand der Unteransprüche.

Der erste elektrochemische Energiespeicher umfasst eine 12V Batterie.

Der zweite elektrochemische Energiespeicher umfasst eine 48V Batterie.

Die elektrischen und/oder elektronischen Komponenten umfassen mindestens einen Mikrocontroller, einen Spannungssensor, einen Stromsensor, einen Temperatursensor, eine Abschaltvorrichtung und/oder mindestens eine Kommunikationsschnittstelle.

Die Leiterplatte umfasst gedruckte Schaltungen. Dadurch kann eine hohe Packungsdichte von elektrischen und/oder elektronischen Komponenten erreicht werden.

Die Filterschaltung umfasst einen PI-Filter. Dadurch können elektromagnetische Störungen reduziert werden.

Der Gleichspannungswandler umfasst einen Abwärtswandler. Dadurch kann eine elektrische Spannung zur Spannungsversorgung der Steuereinheit eingestellt werden.

Der elektrische Schalter umfasst einen Halbleiterschalter. Dadurch können schnelle Schaltzeiten und geringe Schaltverluste erreicht werden.

Erfindungsgemäß umfasst ein Verfahren zum Betreiben der elektrischen Schaltungsanordnung zum sicheren Betreiben mindestens einer Steuereinheit eines Energiespeichersystems mit einem ersten elektrochemischen Energiespeicher und einem zweiten elektrochemischen Energiespeicher im Fehlerfall des ersten elektrochemischen Energiespeichers folgende Schritte:
a) Schalten eines Schalters zum elektrischen Verbinden eines mit einem ersten Anschluss elektrisch verbundenen ersten elektrochemischen Energiespeichers mit elektrischen und/oder elektronischen Komponenten eines ersten Bereiches einer Leiterplatte zur Spannungsversorgung;
b) Wenn ein Fehlerfall des ersten elektrochemischen Energiespeichers vorliegt, schalten eines Schalters zum elektrischen Verbinden eines mit einem zweiten Anschluss elektrisch verbundenen zweiten elektrochemischen Energiespeichers mit einem Gleichspannungswandler zur Spannungsversorgung der von elektrischen und/oder elektronischen Komponenten eines zweiten Bereiches der Leiterplatte, der von dem ersten Bereich durch einen dritten Bereich hochohmig getrennt ist, wobei die Komponenten des zweiten Bereiches eine Steuereinheit umfassen.

Vorteilhafterweise findet eine erfindungsgemäße elektrische Schaltungsanordnung Verwendung in elektrischen Energiespeichern für Elektrofahrzeuge, Hybridfahrzeuge, Plug-In-Hybridfahrzeuge, Luftfahrzeuge, Pedelecs oder E-Bikes, für portable Einrichtungen zur Telekommunikation oder Datenverarbeitung, für elektrische Handwerkzeuge oder Küchenmaschinen, sowie in stationären Speichern zur Speicherung insbesondere regenerativ gewonnener elektrischer Energie.

Es zeigt:

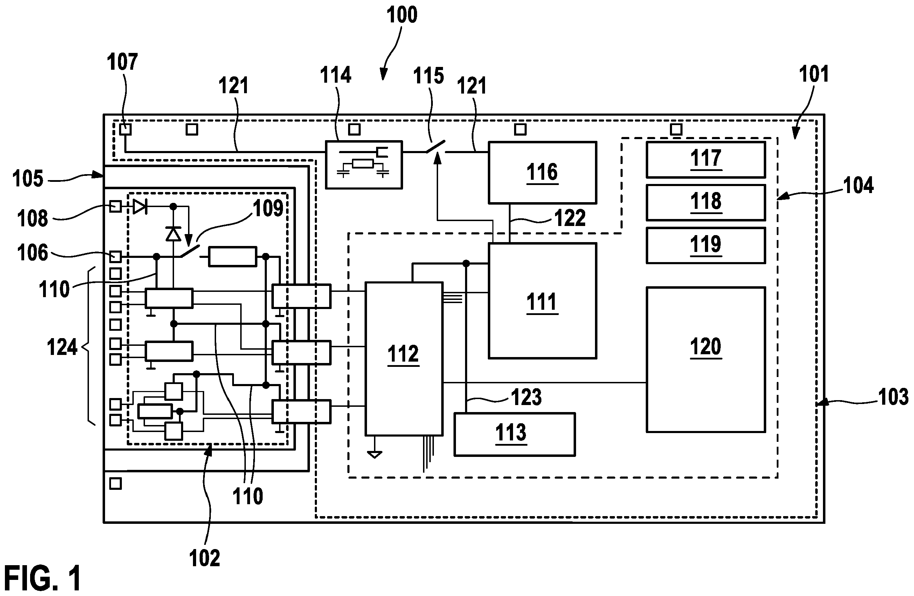

Figur 1 eine schematische Darstellung einer ersten Ausführungsform der erfindungsgemäßen elektrischen Schaltungsanordnung.

### Detaillierte Beschreibung der Ausführungsbeispiele

Figur 1 zeigt eine schematische Darstellung einer ersten Ausführungsform der erfindungsgemäßen elektrischen Schaltungsanordnung 100. Eine Leiterplatte 101 umfasst einen ersten Bereich mit elektrischen und/oder elektronischen Komponenten 102 sowie einen zweiten Bereich 103 mit elektrischen und/oder elektronischen Komponenten 104, die durch einen dritten Bereich 105 voneinander hochohmig getrennt sind.

Die elektrischen und/oder elektronischen Komponenten 102 umfassen einen Spannungssensor und eine Mehrzahl an Kommunikationsschnittstellen, welche mittels weiterer Anschlüsse 124 mit einem Bussystem, beispielsweise einem CAN-Bus, und/oder Sensoren elektrisch verbindbar sind.

Mittels elektrischer Leitungen 110 sind die elektrischen und/oder elektronischen Komponenten 102 mittels eines Schaltelements 109 mit einem ersten Anschluss 106, beispielsweise ein Pluspol eines ersten elektrochemischen Energiespeichers, zur Spannungsversorgung elektrisch verbindbar. Das Schaltelement 109, insbesondere ein Halbleiterschalter, wird mittels eines weiteren Anschlusses 108 geschaltet, beispielsweise über ein Signal, das einen Fahrzeugstart repräsentiert.

Die elektrischen und/oder elektronischen Komponenten 104, beispielsweise Komponenten eines Batteriemanagementsystems, umfassen eine Steuereinheit 111, einen Mikrocontroller 112 sowie eine Abschaltvorrichtung 113, beispielsweise für eine Unterspannungsüberwachung einer Spannungsversorgung 123. Ferner umfassen die elektrischen und/oder elektronischen Komponenten 104 einen Spannungssensor 117, einen Stromsensor 118, einen Temperatursensor 119 und eine Ladezustandsausgleichvorrichtung 120.

Die Steuereinheit 111 ist mit einer elektrischen Leitung 122 mit einem Gleichspannungswandler 116 sowie mit der elektrischen Leitung 123 mit dem Mikrocontroller 112 und der Abschaltvorrichtung 113 zur Spannungsversorgung elektrisch verbunden.

Der Gleichspannungswandler 116 ist über eine elektrische Leitung 121 mittels eines Schaltelements 115 mit einem zweiten Anschluss 107 der Leiterplatte 101 elektrisch verbindbar. Die elektrische Leitung 121 umfasst neben dem Schaltelement 115 eine Filterschaltung 114, insbesondere mit einem PI-Filter, zur Verbesserung der elektromagnetischen Verträglichkeit. Das Schaltelement 115 wird beispielsweise über eine Signalleitung durch die Steuereinheit 111 geschaltet. Hierzu ist die Steuereinheit 111 mit einer Spannungsversorgung elektrisch verbunden. Beispielsweise wird dann bei Fahrzeugstart die Spannungsversorgung durch den zweiten elektrischen Energiespeicher mittels des Schaltelements 115 zugeschaltet, die auch bei einem Ausfall des ersten elektrischen Energiespeichers das Batteriemanagementsystem weiter funktionsfähig ist.

Der Gleichspannungswandler 116, vorteilhafterweise ein Abwärtswandler, wandelt die an dem zweiten Anschluss 107 anliegende elektrische Spannung, beispielsweise 48V, in eine niedrigere elektrische Spannung um, beispielsweise 12V, zur Spannungsversorgung der Steuereinheit 111 mittels der elektrischen Leitung 122.

## Patentansprüche

1. Elektrische Schaltungsanordnung (100) für ein Energiespeichersystem mit einem ersten elektrochemischen Energiespeicher und einem zweiten elektrochemischen Energiespeicher umfassend
- eine Leiterplatte (101) mit mindestens einer Steuereinheit (111), die einen ersten Bereich mit elektrischen und/oder elektronischen Komponenten (102) sowie einen zweiten Bereich (103) mit elektrischen und/oder elektronischen Komponenten (104) umfasst, wobei der erste Bereich (102) und der zweite Bereich (104) der Leiterplatte (101) durch einen dritten Bereich (105) voneinander hochohmig getrennt sind;
- einen ersten Anschluss (106) für die elektrische Spannungsversorgung der Komponenten (102) des ersten Bereiches der Leiterplatte (101) mittels dem ersten Energiespeicher;
- einen zweiten Anschluss (107) für die elektrische Spannungsversorgung der Komponenten (104), die mindestens eine Steuereinheit (111) umfassen, des zweiten Bereiches der Leiterplatte (101) mittels dem zweiten Energiespeicher,
**dadurch gekennzeichnet, dass**
eine elektrische Verbindung (121) zwischen dem zweiten Anschluss (107) und der Steuereinheit (111) eine Filterschaltung (114), einen Gleichspannungswandler (116) sowie ein Schaltelement (115) umfasst, wobei mittels dem Schaltelement (115) die Filterschaltung (114) mit dem Gleichspannungswandler (116) elektrisch verbindbar ist, wodurch die Spannungsversorgung der Steuereinheit (111) unabhängig von dem ersten Energiespeicher durch den zweiten Energiespeicher erfolgt.

2. Elektrische Schaltungsanordnung (100) nach Anspruch 1, **dadurch gekennzeichnet, dass** der erste elektrochemische Energiespeicher eine 12V Batterie umfasst.

3. Elektrische Schaltungsanordnung (100) nach einem der vorhergehenden Ansprüche, **dadurch gekennzeichnet, dass** der zweite elektrochemische Energiespeicher eine 48V Batterie umfasst.

4. Elektrische Schaltungsanordnung (100) nach einem der vorhergehenden Ansprüche, **dadurch gekennzeichnet, dass** die elektrischen und/oder elektronischen Komponenten (103, 104) mindestens einen Mikrocontroller (112), eine Abschaltvorrichtung (113), einen Spannungssensor (117), einen Stromsensor (118), einen Temperatursensor (119), eine Ladezustandsausgleichvorrichtung (120) und/oder mindestens eine Kommunikationsschnittstelle umfassen.

5. Elektrische Schaltungsanordnung (100) nach einem der vorhergehenden Ansprüche, **dadurch gekennzeichnet, dass** die Leiterplatte (101) gedruckte Schaltungen umfasst.

6. Elektrische Schaltungsanordnung (100) nach einem der vorhergehenden Ansprüche, **dadurch gekennzeichnet, dass** die Filterschaltung (114) einen PI-Filter umfasst.

7. Elektrische Schaltungsanordnung (100) nach einem der vorhergehenden Ansprüche, **dadurch gekennzeichnet, dass** der Gleichspannungswandler (116) einen Abwärtswandler umfasst.

8. Elektrische Schaltungsanordnung (100) nach einem der vorhergehenden Ansprüche, **dadurch gekennzeichnet, dass** das Schaltelement (115) einen Halbleiterschalter umfasst.

9. Verfahren zum Betreiben der elektrischen Schaltungsanordnung (100) nach einem der Ansprüche 1 bis 8 zum sicheren Betreiben mindestens einer Steuereinheit (111) eines Energiespeichersystems mit einem ersten elektrochemischen Energiespeicher und einem zweiten elektrochemischen Energiespeicher im Fehlerfall des ersten elektrochemischen Energiespeichers, umfassend folgende Schritte:
a) Schalten eines Schalters (109) zum elektrischen Verbinden eines mit einem ersten Anschluss (106) elektrisch verbundenen ersten elektrochemischen Energiespeichers mit elektrischen und/oder elektronischen Komponenten (102) eines ersten Bereiches einer Leiterplatte (101) zur Spannungsversorgung;
b) Wenn ein Fehlerfall des ersten elektrochemischen Energiespeichers vorliegt, schalten eines Schalters (115) zum elektrischen Verbinden eines mit einem zweiten Anschluss (107) elektrisch verbundenen zweiten elektrochemischen Energiespeichers mit einem Gleichspannungswandler (116) zur Spannungsversorgung der von elektrischen und/oder elektronischen Komponenten (104) eines zweiten Bereiches der Leiterplatte (101), der von dem ersten Bereich (102) durch einen dritten Bereich (105) hochohmig getrennt ist, wobei die Komponenten des zweiten Bereiches (104) eine Steuereinheit (111) umfassen.

10. Verwendung einer elektrischen Schaltungsanordnung (100) nach einem der Ansprüche 1 bis 8 in elektrischen Energiespeichern für Elektrofahrzeuge, Hybridfahrzeuge, Plug-In-Hybridfahrzeuge, Luftfahrzeuge, Pedelecs oder E-Bikes, für portable Einrichtungen zur Telekommunikation oder Datenverarbeitung, für elektrische Handwerkzeuge oder Küchenmaschinen, sowie in stationären Speichern zur Speicherung insbesondere regenerativ gewonnener elektrischer Energie.

## Claims

1. Electrical circuit arrangement (100) for an energy storage system having a first electrochemical energy store and a second electrochemical energy store, comprising
- a printed circuit board (101) having at least one control unit (111) and which comprises a first area having electrical and/or electronic components (102) and a second area (103) having electrical and/or electronic components (104), wherein the first area (102) and the second area (104) of the printed circuit board (101) are isolated from each other at high impedance by a third area (105);
- a first terminal (106) for supplying electrical power to the components (102) of the first area of the printed circuit board (101) by means of the first energy store;
- a second terminal (107) for supplying electrical power to the components (104), which comprise at least one control unit (111), of the second area of the printed circuit board (101) by means of the second energy store, **characterized in that**
an electrical connection (121) between the second terminal (107) and the control unit (111) comprises a filter circuit (114), a DC-DC voltage converter (116) and a switching element (115), wherein the filter circuit (114) is able to be electrically connected to the DC-DC voltage converter (116) by means of the switching element (115), as a result of which the control unit (111) is supplied with power by the second energy store independently of the first energy store.

2. Electrical circuit arrangement (100) according to Claim 1, **characterized in that** the first electrochemical energy store comprises a 12V battery.

3. Electrical circuit arrangement (100) according to either of the preceding claims, **characterized in that** the second electrochemical energy store comprises a 48V battery.

4. Electrical circuit arrangement (100) according to one of the preceding claims, **characterized in that** the electrical and/or electronic components (103, 104) comprise at least one microcontroller (112), a disconnection apparatus (113), a voltage sensor (117), a current sensor (118), a temperature sensor (119), a state-of-charge balancing apparatus (120) and/or at least one communication interface.

5. Electrical circuit arrangement (100) according to one of the preceding claims, **characterized in that** the printed circuit board (101) comprises printed circuits.

6. Electrical circuit arrangement (100) according to one of the preceding claims, **characterized in that** the filter circuit (114) comprises a PI filter.

7. Electrical circuit arrangement (100) according to one of the preceding claims, **characterized in that** the DC-DC voltage converter (116) comprises a step-down converter.

8. Electrical circuit arrangement (100) according to one of the preceding claims, **characterized in that** the switching element (115) comprises a semiconductor switch.

9. Method for operating the electrical circuit arrangement (100) according to one of Claims 1 to 8 for the safe operation of at least one control unit (111) of an energy storage system having a first electrochemical energy store and a second electrochemical energy store in the event of a fault in the first electrochemical energy store, comprising the following steps:
a) switching a switch (109) in order to electrically connect a first electrochemical energy store, which is electrically connected to a first terminal (106), to electrical and/or electronic components (102) of a first area of a printed circuit board (101) so as to supply them with power;
b) in the event of a fault in the first electrochemical energy store, switching a switch (115) in order to electrically connect a second electrochemical energy store, which is electrically connected to a second terminal (107), to a DC-DC voltage converter (116) so as to supply power to the electrical and/or electronic components (104) of a second area of the printed circuit board (101) which is isolated from the first area (102) at high impedance by a third area (105), wherein the components of the second area (104) comprise a control unit (111).

10. Use of an electrical circuit arrangement (100) according to one of Claims 1 to 8 in electrical energy stores for electric vehicles, hybrid vehicles, plug-in hybrid vehicles, aircraft, pedelecs or e-bikes, for portable devices for telecommunication or data processing, for electric hand tools or kitchen appliances, and in stationary stores for storing in particular regeneratively produced electrical energy.

## Revendications

1. Ensemble de circuits électriques (100) pour un système d'accumulation d'énergie pourvu d'un premier accumulateur d'énergie électrochimique et d'un deuxième accumulateur d'énergie électrochimique, comprenant
- une carte de circuits imprimés (101) pourvue d'au moins une unité de commande (111) qui comprend une première zone pourvue de composants (102) électriques et/ou électroniques ainsi qu'une deuxième zone (103) pourvue de composants (104) électriques et/ou électroniques, dans laquelle la première zone (102) et la deuxième zone (104) de la carte de circuits imprimés (101) sont séparées l'une de l'autre en haute impédance par une troisième zone (105) ;
- une première borne (106) pour l'alimentation en tension électrique des composants (102) de la première zone de la carte de circuits imprimés (101) au moyen du premier accumulateur d'énergie ;
- une deuxième borne (107) pour l'alimentation en tension électrique des composants (104), qui comprennent au moins une unité de commande (111), de la deuxième zone de la carte de circuits imprimés (101) au moyen du deuxième accumulateur d'énergie,
**caractérisé en ce qu'**une liaison électrique (121) entre la deuxième borne (107) et l'unité de commande (111) comprend un circuit de filtrage (114), un convertisseur continu-continu (116) ainsi qu'un élément de commutation (115), dans lequel l'élément de commutation (115) permet de relier électriquement le circuit de filtrage (114) au convertisseur continu-continu (116) de sorte que l'alimentation en tension de l'unité de commande (111) est effectuée indépendamment du premier accumulateur d'énergie par le deuxième accumulateur d'énergie.

2. Ensemble de circuits électriques (100) selon la revendication 1, **caractérisé en ce que** le premier accumulateur d'énergie électrochimique comprend une batterie 12 V.

3. Ensemble de circuits électriques (100) selon l'une quelconque des revendications précédentes, **caractérisé en ce que** le deuxième accumulateur d'énergie électrochimique comprend une batterie 48 V.

4. Ensemble de circuits électriques (100) selon l'une quelconque des revendications précédentes, **caractérisé en ce que** les composants électriques et/ou électroniques (103, 104) comprennent au moins un microcontrôleur (112), un dispositif de déconnexion (113), un capteur de tension (117), un capteur de courant (118), un capteur de température (119), un dispositif de compensation d'état de charge (120) et/ou au moins une interface de communication.

5. Ensemble de circuits électriques (100) selon l'une quelconque des revendications précédentes, **caractérisé en ce que** la carte de circuits imprimés (101) comprend des circuits imprimés.

6. Ensemble de circuits électriques (100) selon l'une quelconque des revendications précédentes, **caractérisé en ce que** le circuit de filtrage (114) comprend un filtre PI.

7. Ensemble de circuits électriques (100) selon l'une quelconque des revendications précédentes, **caractérisé en ce que** le convertisseur continu-continu (116) comprend un convertisseur abaisseur.

8. Ensemble de circuits électriques (100) selon l'une quelconque des revendications précédentes, **caractérisé en ce que** l'élément de commutation (115) comprend un commutateur à semi-conducteur.

9. Procédé permettant de faire fonctionner l'ensemble de circuits électriques (100) selon l'une quelconque des revendications 1 à 8 pour le fonctionnement sûr d'au moins une unité de commande (111) d'un système d'accumulation d'énergie comprenant un premier accumulateur d'énergie électrochimique et un deuxième accumulateur d'énergie électrochimique en cas de défaillance du premier accumulateur d'énergie électrochimique, comprenant les étapes suivantes consistant à :
a) commuter un commutateur (109) pour connecter électriquement un premier accumulateur d'énergie électrochimique relié électriquement à une première borne (106) à des composants (102) électriques et/ou électroniques d'une première zone d'une carte de circuits imprimés (101) en vue de l'alimentation en tension ;
b) en cas de défaillance du premier accumulateur d'énergie électrochimique, commuter un commutateur (115) pour connecter électriquement un deuxième accumulateur d'énergie électrochimique électriquement relié à une deuxième borne (107) à un convertisseur continu-continu (116) en vue de l'alimentation en tension des composants électriques et/ou électroniques (104) d'une deuxième zone de la carte de circuits imprimés (101) qui est séparée en haute impédance de la première zone (102) par une troisième zone (105), les composants de la deuxième zone (104) comprenant une unité de commande (111).

10. Utilisation d'un ensemble de circuits électriques (100) selon l'une quelconque des revendications 1 à 8 dans des accumulateurs d'énergie électrique destinés à des véhicules électriques, des véhicules hybrides, des véhicules hybrides rechargeables, des aéronefs, des vélomoteurs ou des vélos électriques, pour des dispositifs portables destinés à la télécommunication ou au traitement de données, pour des outils à main électriques ou des appareils électroménagers, ainsi que dans des accumulateurs stationnaires pour accumuler de l'énergie électrique, en particulier obtenue par régénération.
